Europäisches Patentamt

European Patent Office

Office européen des brevets

(11) Publication number: **0 423 761 A2**

# EUROPEAN PATENT APPLICATION

(21) Application number: 90119918.2

(51) Int. Cl.5: **H01L 21/00, B08B 7/00**

(22) Date of filing: 17.10.90

(30) Priority: 17.10.89 US 422864

(43) Date of publication of application:
24.04.91 Bulletin 91/17

(84) Designated Contracting States:
BE CH DE ES FR GB IT LI NL

(71) Applicant: APPLIED MATERIALS, INC.
P.O. Box 58039 3050 Bowers Avenue
Santa Clara California 95052(US)

(72) Inventor: Lorimer, D'Arcy
2584 Knightsbridge Lane
Santa Clara CA 95051(US)

Inventor: Liu, Benjamin Y.H.
1 North Deep Lake Road
North Oaks, Minnesota 55110(US)
Inventor: Baker, Edward
2424 Whitney Drive
Mountain View, CA 94043(US)
Inventor: Ahn, Kang Ho
1611 Pleasant St. Apt.208
Lauderdale, Minnesota 55108(US)

(74) Representative: Diehl, Hermann Dr. et al
Diehl & Glaeser, Hiltl & Partner
Flüggenstrasse 13
W-8000 München 19(DE)

(54) Apparatus and method for particle removal by forced fluid convection.

(57) An apparatus and method for removing contaminant particles from a surface, such as a semiconductor wafer (12), using the effect of a phase change of a condensate fluid, from liquid to solid form, on the adhesion force between a contaminant particle and a surface. Contaminant particles (172) are removed from a surface by wetting the particles with a thin film (20) of a removal fluid of a type that exhibits a volume expansion during a liquid to solid phase change, and then freezing the removal fluid to cause such expansion . Frozen material (21) including contaminant particles (172) is then removed from the surface by melting and throw-off of frozen material. Steam may be used for both the removal fluid and for melting the frozen material.

FIG.-7

FIG.-8

$*, 1 Å = 0.1 nm.$

## APPARATUS AND METHOD FOR PARTICLE REMOVAL BY FORCED FLUID CONVECTION

The present invention relates to method and apparatus for removing particulate matter from article surfaces.

In the manufacture of semiconductor wafers, initial yields of perfect integrated circuit chips are often of the order of twenty to thirty percent. A major reason for low yields in commercial semiconductor wafer manufacture is the inability to achieve uniform and consistent cleanliness during the manufacturing process. For example, on many semiconductor devices, the distance of separation between adjacent electrically conductive paths of a circuit may be of the order of one micron ("$\mu$m") or less, often as low as 0.25 $\mu$m , in some experimental devices. By way of comparison, a human hair typically has a diameter of seventy $\mu$m . In semiconductor integrated circuit manufacture, an empirically established "twenty percent rule" requires that, if a critical dimension of a circuit is x $\mu$m , all contaminant particles of the size exceeding 0.2x $\mu$m should be removed from the circuit in order to reasonably assure acceptable operation of the circuit.

Various methods have been employed in the field of precision cleaning, including ultrasonics, megasonics, wiping, brush scrubbing, low pressure surfactant spraying, high pressure jet spraying, etching and centrifugal spraying. Ultrasonic cleaning generates considerable noise at frequencies below 30 kilohertz; and, at higher frequencies of the order of 80-100 kilohertz and higher, surface features of semiconductor-materials such as photoresist are likely to be damaged by the radiation field. Megasonic cleaning requires batch processing and does not allow continuous feed processing; and the solvent to be used must be chosen carefully; strong hydrofluoric acid and similar cleaning solutions cannot be used. Surface wiping is useful only for removal of larger contaminant particles and is not useful for cleaning irregular, non-planar surfaces; contaminant particles may be deposited on the surface from the solvent or the wiper itself. Brush scrubbing requires that the scrubbed parts be dried and the scrubbing solution or brush may deposit contaminants or unwanted thin films on the surface, especially a hydrophilic surface; and only one side or surface can be cleaned at a time. Low pressure surfactant spraying must rely on detergent action of the spray solution itself as the pressure used, typically 5-80 psi * is insufficient by itself to remove small contaminant particles, especially those of diameter 0.5-1 $\mu$m or less. High pressure jet spraying relies on liquid jet velocities of 100-4000 psi * , which requires that the article to be cleaned be securely anchored and precludes use of such spraying on surfaces with non-robust features.

Surface etching requires use and continuing replacement of special liquid solutions that form soluble complexes on the surface; "replating" of the surface is sometimes a problem, and etching is a multi-step, time consuming process. Centrifugal spray cleaning relies on a combination of centrifugal force and high pressure spraying and has many of the same problems as high pressure spraying.

A method for contaminant removal of particles from a silicon wafer surface, using the freezing of water or other similar fluid around the particle, is disclosed in U.S. Pat. No. 4,777,804, issued to Bowling et al. A frozen crystal which nucleates around a contaminant particle enlarges the particle. The particle plus contaminant is then removed from the surface by brush scrubbing or some other technique that does not allow warming of the frozen layer.

The following Table I presents the current state of the art of methods for surface particle removal:

* 1 psi = 0.069 bar

Table I.

| Comparison of cleaning process features. | | | |
|---|---|---|---|
| METHOD | CLEANING MECHANISM | LOWER LIMIT PARTICLE SIZE | GENERAL CHARACTERISTICS |
| ultrasonic | cavitation | 25 $\mu$m | frequency range of 18 to 100 kilohertz; may damage surface |
| megasonic | high pressure waves | 0.2 $\mu$m | frequency range 8/10 to 1 megahertz; 15 minutes duration |
| wiping | shear | 5 $\mu$m | time-consuming |
| brush scrubbing | mechanical and shear | 0.5 $\mu$m | does not work well on hydrophilic surface |
| low pressure spray | mechanical and detergency | 0.2 $\mu$m | pressure range of 5 to 80 pounds per inch*; relatively time-consuming |
| high pressure spray | shear | 0.2 $\mu$m | pressure range of 100 to 4,000 psi*; relatively slow; can damage surface |
| etching | oxidation and dissolution | | high pH solutions oxidize organic contaminants; low pH solutions desorb metals; time-consuming |
| centrifugal spray | centrifugal shear and solvency | | series of fine sprays sprays at 2,500 psi* harmful chemicals; time-consuming |

* 1 psi = 0.069 bar

Each of the cleaning methods heretofore discussed requires either the use of an active mechanical component, the use of special chemical solutions, or labor-intensive human participation in order to achieve a satisfactory level of effectiveness. Furthermore, each cleaning method discussed is limited to a particular class of media to be cleaned, and, given the stringent requirements of certain industries, the absolute cleaning effectiveness of each method is not yet at a uniform, commercially acceptable level. Currently, such methods are limited to removal of contaminant particles that are 0.3 $\mu$m or larger in diameter.

It is an object of the present invention to remove very small particles from a surface, such as a semiconductor wafer surface. This object is solved by the apparatus of independent claims 1 and 14 and the method of independent claim 20. Further advantageous features of the apparatus and method are evident from the dependent claims, the description and the drawings. The claims are intended to be a first non-limiting approach of defining the invention in general terms.

The invention provides an apparatus and method that utilizes the effect of a phase change of a condensate or fluid, herein called a "removal fluid", from liquid to solid form, on the adhesion force between a contaminant particle and an adjacent surface. In particular, particles are removed from a surface of an article by freezing removal fluid on the surface and then removing frozen material by at least partial melting and collecting the melted fluid. The specific method involved is related to the volume expansion and other properties of the removal fluid during the freezing process, as well as properties of the contaminants and the support surface.

Briefly, the present method involves coating particles on the surface to be cleaned with a thin layer of removal fluid, preferably steam or a mixture of steam and a miscible solvent such as isopropyl alcohol or isobutyl alcohol. The removal fluid should completely wet or coat the surface of the particles. Sometimes wetting agents may be used in conjunction with the removal fluid. The removal fluid is then caused to freeze, forming either a thin, frozen condensate on the supported particles or a layer of removal fluid that entraps small particles in the frozen layer. As the condensate begins to freeze around the small particles, the separation distance between the contaminant particles and the surface tends to increase due to the volume expansion of the condensate upon freezing. This increase in separation distance reduces the adhesion force between the contaminant particles and the surface, which allows easier removal of these particles from the surface. Removal of the contaminant particles, either as discrete particles coated with condensate or as a frozen layer entrapping contaminant particles, is accomplished by forced fluid convection, e.g. making use of centrifugal forces, rinsing with a warm fluid, or melting from the underside and throw-off of the frozen layer material. "Fluid convection" is defined here as particle travel across the

EP 0 423 761 A2

article surface, as opposed to removal by physical contact, as in brushing a surface or wiping. Sometimes discrete particles will coalesce with other particles, blending their coatings of condensate into a frozen layer.

Uniform deposition of a particle capture layer is promoted by rotation of a surface to be cleaned during exposure to a removal fluid. The fluid nucleates on the contaminant particles and forms a thin layer over the exposed surface. The method for removing the frozen layer of condensate involves partially or fully melting the frozen condensate from the surface, preferably by exposure to steam. When the frozen condensate or layer is partially melted it may simply slide off the surface. To facilitate the partial melt sliding off the surface, the surface may be inclined or spun, making use of a centrifugal force.

To aid melting of the frozen material at the desired surface, the surface to be cleaned may be heated from below the surface by a heat source. Methods for removing the frozen condensate or layer that do not involve complete melting of the layer include use of strong rotational or centrifugal forces to throw off the frozen material from the surface. The frozen layer may be thrown off by quickly changing the direction of rotation. Ultrasonic or megasonic vibration of the article to be cleaned may also be combined with the rotation of the surface to help free frozen material from the surface.

Fig. 1 is an elevational view of apparatus in accord with the present invention.

Fig. 2 is a sectional plan view of a vacuum chuck employed in the apparatus of Fig. 1.

Fig. 3 is a top view of the vacuum chuck shown in Fig. 2.

Fig. 4 is a sectional view of a wafer cleaning chamber in accord with the present invention.

Fig. 5 is an enlarged view of a gas shroud plan for a wafer chuck shown in Fig. 4.

Fig. 6 is a block diagram of the system used to practice the invention.

Figs. 7 and 8 are schematic views depicting the separation distance between a particle and a surface during a phase change.

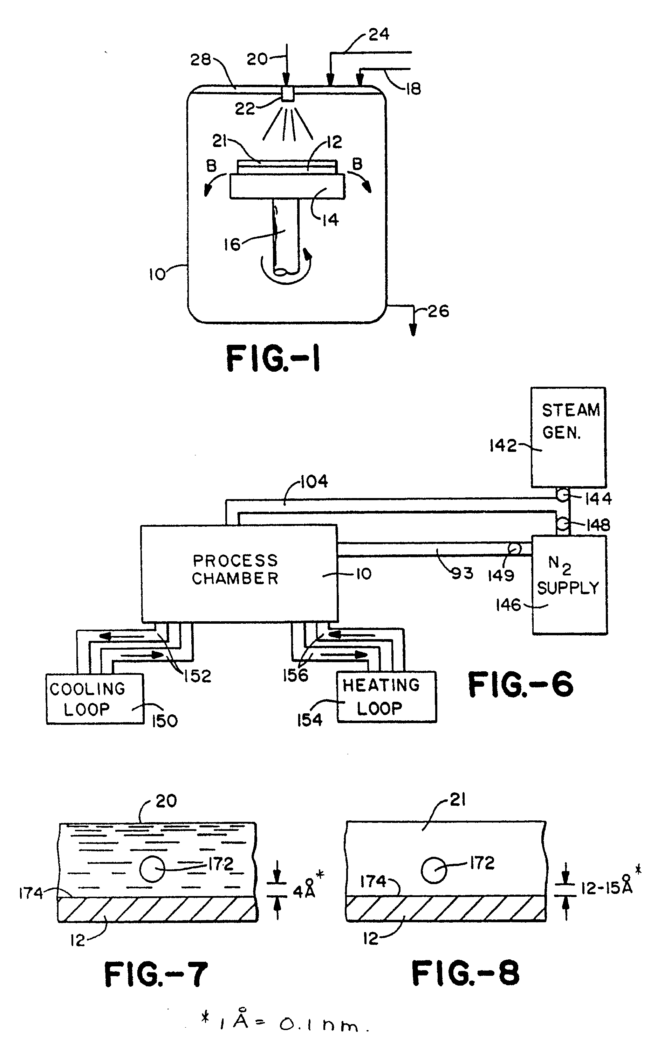

With reference to Fig. 1, apparatus for cleaning a surface is depicted embodying a chamber 10 suitable for housing a semiconductor wafer or article 12 supported on pedestal 14 which is joined to a rotatable spindle 16. The pedestal is heated to about 60 °C to drive off any moisture on the pedestal prior to placement of a wafer thereon. Once the wafer 12 has been placed inside chamber 10, the chamber is closed and the cleaning process may begin by purging the chamber with an inert gas 18, such as nitrogen, helium, neon or argon. The pedestal, a wafer chuck, is cooled to a temperature below which a cleaning fluid will freeze thereon. The cleaning process continues with spraying steam 20 or ultra-pure water vapor or another suitable removal fluid into the chamber 10 via a nozzle 22. Nitrogen flow is maintained simultaneously as described below. Other suitable removal fluids include mixtures of water vapor and isobutyl alcohol or isopropyl alcohol, where the alcohol percentage is no more than 10-20 percent. These fluids manifest a volume expansion as the liquid freezes and passes to a solid state, as does water. The removal fluid 20 is applied only to the extent necessary to coat particulates by condensation or to coat and wet the surface of the wafer 12 to thereby entrap particulates. Wetting agents such as isopropyl alcohol and ammonia may be introduced into the chamber during purging of other gases therefrom, or as freezing of the removal fluid occurs.

The surface of the wafer 12 is preferably cooled below the freezing point of the removal fluid 20 by either of two methods. The first method requires injection into the chamber a cooling gas 24, such as cold air or nitrogen with a temperature below the freezing temperature of the removal fluid 20. Circulation of cooling gas 24 through the chamber 10 causes removal fluid to freeze and either condense on contaminant particles in a frozen state or form a frozen layer 21. As the removal fluid 20 freezes on the surface of the wafer 12, contaminant particles on the surface become trapped in the frozen layer 21. The frozen layer 21 that forms on the surface is preferably one to two $\mu$m thick but may be as thick as ten $\mu$m or even more. Freezing action decreases the adhesion force between the surface of wafer 12 and the contaminant particles, by increasing the separation distance between the wetted contaminant particles and the surface. The pedestal or wafer chuck may be cyclically heated to 60 °C, then cooled to the low temperature previously mentioned, then heated, and so on, in order to loosen tightly bound particles stuck to the surface.

Once the cyclic freezing and heating process is completed, the contaminant particles are removed from the surface by simply removing the frozen material, e.g., by melting under the influence of steam or liquid water and/or alcohol. A chamber drain 26 is used to remove the material, whether melted or frozen, including contaminant particles, from the chamber 10. The proper timing of the steps used during the cleaning process may be determined experimentally, or sensors may be used within the chamber to determine when a process step is complete.

In a second method, temperature control of the wafer chuck may be achieved by circulation of a cooling fluid, maintained at a temperature T less than the freeze temperature $T_{freeze}$ of the condensate, through a circuitous or serpentine path within the chuck or pedestal 14 that supports the wafer 12.

4

Circulation of this cooling fluid within the pedestal 14 lowers the temperature of the pedestal, of the wafer 12 to be cleaned and of the removal fluid 20 on the designated surface to be cleaned, to a temperature T < $T_{freeze}$ so that condensate or a frozen layer 21 is formed on the designated surface. An example of a pedestal with a circulating fluid is found in U.S. Patent No. 4,628,991, issued to Hsiao et al. The cooling fluid may be replaced by a heating fluid for the heating cycle.

The pedestal or other article support means 14 may be a vacuum chuck that, in its activated state, holds the wafer 12 against one face of the vacuum chuck by vacuum forces. The pedestal 14 should be capable of holding the wafer 12 so that the pedestal can be rapidly rotated about an axis without slipping of the wafer.

Rotating the wafer 12 while the removal fluid 20 is condensed onto the wafer in the form of steam or other vapor or liquid, causes a thin film of this fluid to form on the surface of the wafer. This is then frozen as described above. Alternatively, the wafer can be held stationary during this step. Later, the crystals or frozen layer 21 may then be removed from the surface, for example, by melting the layer, by depositing warm vapor condensate, e.g. from steam, on the vapor surface. Increasing the speed of rotation or suddenly changing the direction of rotation in an agitating manner aids in clearing removal fluid from the wafer surface. The wafer 12 may also be vibrated during rotation to help loosen the frozen material 21 from the surface. If the removal fluid 20 used in the cleaning process is steam, a preferred fluid, it is de-ionized and ultra-pure, containing only a few parts per billion of impurities. In general, impurities in gases are fewer than impurities in liquids and so vapor condensation is preferable for forming the frozen material on contaminants. The surface may then be dried by circulating an inert gas, such as nitrogen, helium, neon or argon through the chamber 10.

A preferred material for the inside surfaces at chamber 10 is polyvinyl difluoride or other rigid non-porous thermoplastic material, known for its chemical resistance and good thermal insulation. Typically, the chamber 10 has a cylindrical or annular shape and has a sealable cover 28 to allow vapors 12 to be deposited in and removed from the chamber. To prevent contaminant particles from entering the chamber 10 with the wafer 12 therein, the chamber may be sealed and pressurized to a pressure slightly above the ambient barometric pressure to preclude entry of additional contaminants into the chamber 10.

Heating the pedestal or chuck while rotating the wafer 12 will aid in throwing off this material from the wafer.

Once the wafer has been cleared of frozen material, the entire freeze and thaw cycle may be repeated one or more times, a recommended procedure, or the wafer may be dried. For drying, the chuck is heated and dry nitrogen is run as a purge gas.

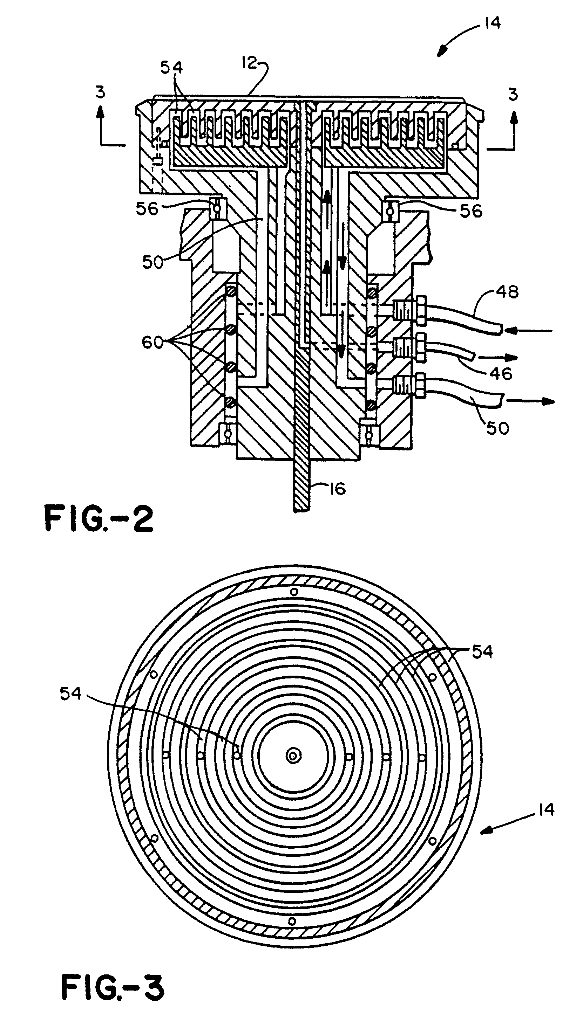

Referring to Figs. 2 and 3, a pedestal or chuck 14 supports a wafer 12 by utilizing vacuum. A vacuum force is supplied to the vacuum chuck 14 through a vacuum line 46 that is connected to a vacuum source, not shown. A fluid inlet line 48 and fluid outflow line 50 provide circulation of a warming or cooling fluid through the vacuum chuck 44 via internal serpentine channels 54 in the chuck 14. This allows for warming or cooling of the wafer 12. Bearings 56 allow the vacuum chuck 44 to rotate about a spindle 16. Typical rotational speeds of 100-1500 rpm are anticipated during operation. Rotation seals 60 are used to contain the warming and cooling fluids.

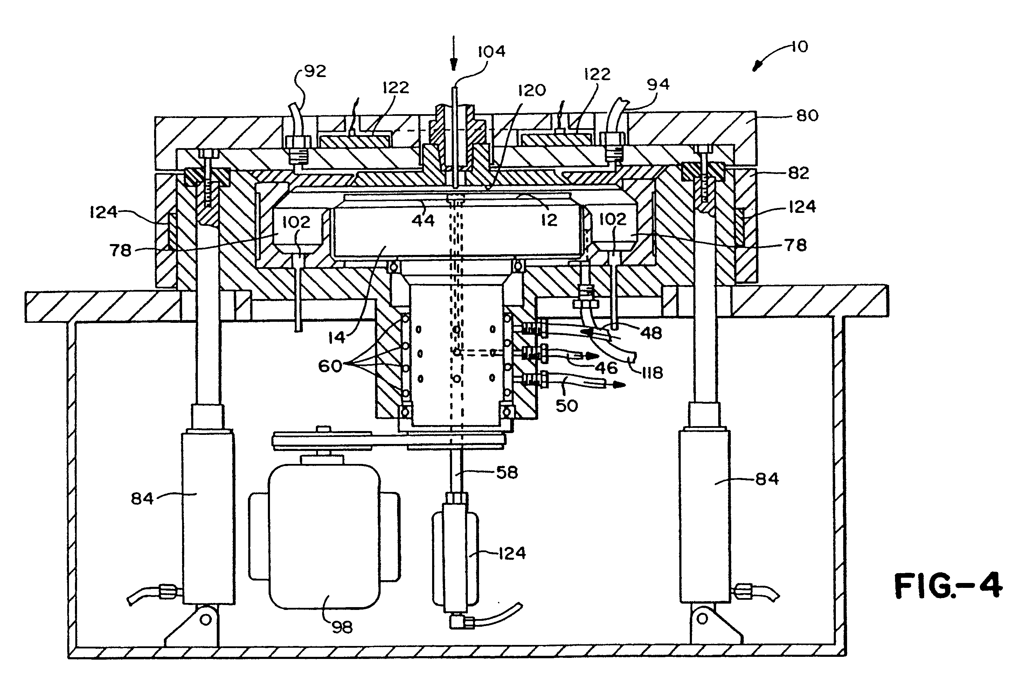

Referring to Fig. 4, the chamber 10, now shown in detail, employs the vacuum chuck 14 that is activated by a vacuum inlet port and line 46. The chuck 14 is supported centrally within an annular plenum 78 defined by a movable top wall 80 and a lower support unit 82. The top wall 80 may be moved to open or close the plenum 78 by pneumatic actuators 84. A semiconductor wafer 12 is positioned on the chuck 14. The wafer 12 may be lifted or positioned vertically by means of a pedestal spindle 58, for loading a wafer into and removing a wafer from the chamber. The chamber is shrouded by an inert gas, such as $N_2$. The shroud is a gas curtain, partially separating central regions of the chamber where the chuck resides from peripheral regions for the purpose of isolating peripheral regions. In this manner, particulates generated by spindle motion are prevented from reaching the wafer surface. Shroud gas is introduced into the chamber via inlet ports 92 and 94. A central conduit 104 dispenses purge gas, cleaning fluid, drying gas for the central region of the chamber at appropriate times. The chuck 14 is rotatable about its axis by a drive train coupled to a motor 98 through spindle 58.

To keep condensate from forming on the top wall 120 and dripping onto the wafer 12, heating elements 122 may be used to maintain the temperature of the top wall above the dew point of the removal fluid. The thrown-off material from the rotating wafer 12 is collected in the annular plenum 78 for later removal through drain 118. A drying gas for drying the wafer may be introduced into the plenum 78 via the central conduit 104. Heating elements 124 in the bottom wall 82 help stabilize the temperature of the chamber.

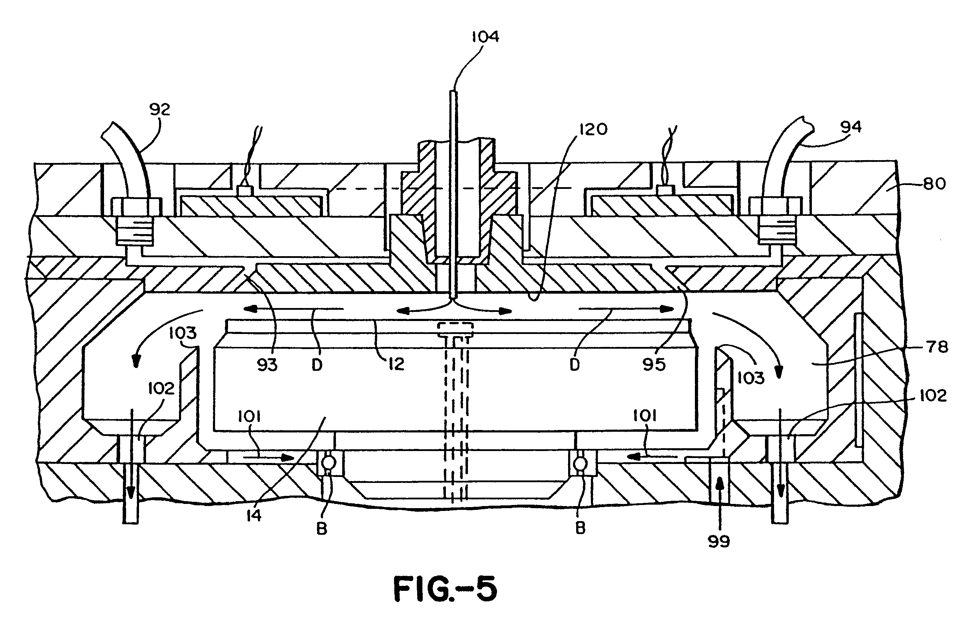

With reference to Fig. 5 the details of the gas shroud are shown for wafer chuck 12. Gas which is introduced into gas shroud inlet ports 92 and 94 is directed by means of angled nozzles 93 and 95 into the

5

annular plenum 78. It is important to have a unidirectional flow of the gas over the wafer surface to prevent recirculation eddies caused by the rotating chuck. These eddies can contain impurities which would be deposited back onto the wafer surface. Inlet flow 104 in combination with purge flows 92 and 94 must be high enough to prevent the formation of these recirculation eddies.

Shroud gas is also introduced through the channel 99 below the wafer chuck. This gas has two purposes. It purges rotation bearings B to prevent moisture condensation and ice during cold chuck operation. It also prevents particles generated in these bearings from entering the process chamber. This is accomplished by designing the passage dimensions in such a way as to cause the gas flow to split via passages 101 and 103. Exit ports 102 in the bottom of the plenum allow draining of fluid thrown off from the wafer, as well as exiting of circulating plenum shroud gas. The width of the plenum should be sufficient to allow adequate capture of thrown off fluid material.

Fig. 6 illustrates the fluid supply systems of the invention. Process chamber 10 contains the wafer whose surface is to be cleaned. Steam from a steam generator 142 is released into the process chamber 10 through conduit 104 by means of a valve 144. A purging and shroud gas, such as $N_2$, from a gas supply 146 is released into the process chamber 10 by means of valves 148 and 149 at appropriate times. Gas for the central region of chamber 10 is delivered through a conduit 104, while shroud gas is delivered via conduit 93. A cooling fluid supply 150 or a heating fluid supply 154 delivers fluids, as needed, to the process chamber 10 by means of conduits 152 or heating conduits 156, respectively forming a recirculating cooling and heating loop.

The effect of the phase change of the removal fluid 20 from liquid to solid, through freezing, on the separation of a contaminant particle at a surface is demonstrated in Figs. 7 and 8. As shown in Fig. 7, a contaminant particle 172 is adjacent to a surface 174 of the wafer 12, with the particle 172 being coated with a thin film of removal fluid 20. Current adhesion theory predicts that a contaminant particle 172 having a radius of 500 Å * (Angstroms) will be suspended from the surface of the wafer 12 by a distance of about 4 Å. *

However, as shown in Fig. 8, as the removal fluid 20 freezes, perhaps becoming a frozen condensate layer 21, the volume occupied by the condensate expands, causing the contaminant particle 172 to move away from the surface 174 of the wafer 12, thereby greatly increasing the separation distance between the contaminant particle 172 and the wafer 12. In particular, the distance increases from 4 Å * to a distance of approximately 12-15 Å * upon formation of the frozen material 21. This greatly reduces the adhesion force, which is believed to arise from attractive forces between the contaminant particle 172 and the wafer surface 174. The reduction of the adhesion force allows the particle to be removed from the surface with relative ease.

After the frozen material 21 has formed on the wafer 12 or on the contaminant particle 172, the frozen material may be caused to thaw and to freeze again. This thaw and freeze process may increase the distance of the contaminant particle 172 from the wafer 12 relative to the corresponding distance in the frozen material 21 that is formed the first time, thereby further decreasing the adhesion of the contaminant particle to the wafer surface 174. This thaw and freeze cycle may be performed once or many times using the same frozen removal fluid 21.

## Claims

1. Apparatus for removing contaminant particles from a surface of an article (12) comprising,
means (22) for directing removal fluid (20) toward the surface of an article to be cleaned,
means (150, 152) for freezing the removal fluid on the surface, and
means (16, 154, 156) for removing frozen removal fluid (21) from the surface.

2. The apparatus of claim 1 further comprising a closeable chamber (10) having an article support (14) therein.

3. The apparatus of claim 1 or 2 wherein said means for directing removal fluid includes a nozzle (22) connected to a steam generator (142).

4. The apparatus of one of the preceding claims wherein said means for freezing the removal fluid comprises a cooling loop (150, 152) connected to the article support (14).

5. The apparatus of one of the preceding claims wherein said means for removing frozen material comprises a heating loop (154, 156) connected to the article support (14).

6. The apparatus of one of claims 3 to 5 wherein said nozzle (22) is connected to a supply (146) of gas

*1 Å = 0.1 nm

EP 0 423 761 A2

which is generally inert.

7. The apparatus of one of claims 2 to 6 wherein said chamber (10) includes at least one gas inlet means (92, 94, 99) for providing a gas shroud about the periphery of the article support (10).

8. The apparatus of one of the claims 2 to 7 wherein said chamber (10) includes an annular plenum (78) about said article support (14) and at least one gas inlet means (92, 94, 99) for providing a gas shroud about the periphery of the article support, said gas shroud extending into said annular plenum (78).

9. The apparatus of claim 8 wherein said annular plenum (78) has an annular wall (103) defining an inwared radial periphery of the plenum and spacing the plenum from the article support (14).

10. The apparatus of one of claims 2 to 9 wherein said chamber (10) has thermally insulative and chemically non-reactive walls with heating means (122, 124) therein for thermal stability.

11. The apparatus of one claims 2 to 10 wherein said article support (14) is a wafer chuck in fluid communication whith said means for freezing the removal fluid and said means for removing frozen material.

12. The apparatus of claim 11 wherein said wafer chuck (14) includes a serpentine channel (54) defined therein.

13. The apparatus of claim 11 or 12 wherein said wafer chuck (14) further comprises means (58, 98) for spinning said wafer chuck (14).

14. Apparatus for removing contaminant particles from an article with opposed planar major surfaces, especially according to one of the preceding claims, the apparatus comprising :

a sealable chamber (10) to house the article (12) support means (14) within the chamber (10) to support the article (12) so that a planar surface is exposed,

fluid flow (20, 22) means for dispensing removal fluid (20) onto the planar surface,

means (150, 154) for changing the temperature of the article support (14) between a temperature where said removal fluid freezes on said support means and a temperature where said frozen removal fluid melts, and

means (102) for removing melted removal fluid from the chamber (10).

15. The apparatus of claim 14 wherein said fluid flow means includes a nozzle (22) connected to a steam generator (142).

16. The apparatus of claim 15 wherein said nozzle (22) is also connected to a supply (146) of gas which is generally inert.

17. The apparatus of one of claims 14 to 16 wherein said chamber includes at least one gas inlet means (92, 94, 99) for providing a gas shroud about the periphery of the article support (14).

18. The apparatus of one of claims 14 to 17 wherein said chamber (10) includes a annular plenum (78) about said support means (14) and at least one gas inlet means (92, 94, 99) for providing a gas shroud about the periphery of said support means (14), the gas shroud extending into said annular plenum (78).

19. The apparatus of one of claims 14 to 18 wherein said support means (14) comprises a serpentine channel (54) defined therein and a motor (98) for spinning the support means (14).

20. A method for removing particles from a designated surface of an article, the method comprising the steps of :

directing a removal fluid toward a designated surface of an article having contaminant particles thereon, so that removal fluid wets the particles, where upon passing from a liquid state to a solid state;

freezing the removal fluid to thereby form a thin layer of frozen removal fluid on the designated surface; and removing the frozen material from the designated surface.

21. The method of claim 20, wherein said step of removing said frozen material is carried out by:

melting at least a portion of said frozen material and removing the melted material from said surface.

22. The method of claim 20 or 21, further comprising the steps of :

causing said frozen material to melt and to refreeze on said designated surface at least once before said frozen material is removed from said designated surface.

7

# FIG.-1

# FIG.-6

STEAM GEN.

PROCESS CHAMBER

COOLING LOOP

HEATING LOOP

N₂ SUPPLY

# FIG.-7

# FIG.-8

*1 Å = 0.1 nm.

FIG.-2

FIG.-3

FIG.-4

EP 0 423 761 A2

FIG.-5

EP 0 423 761 A2